# EUROPEAN PATENT APPLICATION

(11) **EP 4 311 043 A1**
(43) Date of publication of application: **24.01.2024**
(21) Application number: 22771148.8
(22) Date of filing: 04.03.2022
(51) Int. Cl.: H01S 5/11, H01S 5/185, H01S 5/20

(54) **PHOTONIC CRYSTAL SURFACE-EMITTING LASER AND METHOD FOR MANUFACTURING SAME**

(30) Priority: 19.03.2021 JP 2021045486
(71) Applicant: SUMITOMO ELECTRIC INDUSTRIES, LTD., Osaka-shi, Osaka 541-0041 (JP); Kyoto University, Kyoto-shi, Kyoto 606-8501 (JP)
(72) Inventor: FUJIWARA, Naoki, Osaka-shi, Osaka 541-0041 (JP); KONO, Naoya, Osaka-shi, Osaka 541-0041 (JP); FURUYA, Akira, Osaka-shi, Osaka 541-0041 (JP); ITO, Yuki, Osaka-shi, Osaka 541-0041 (JP); NODA, Susumu, Kyoto-shi, Kyoto 606-8501 (JP); INOUE, Takuya, Kyoto-shi, Kyoto 606-8501 (JP); ISHIZAKI, Kenji, Kyoto-shi, Kyoto 606-8501 (JP)
(74) Representative: Grünecker Patent- und Rechtsanwälte PartG mbB
(86) International application number: PCT/JP2022/009415
(87) International publication number: WO 2022/196394

(57) **Abstract**

A photonic crystal surface-emitting laser includes a light emitting region from which light is emitted in a direction crossing an in-plane direction, and a current blocking region that is adjacent to the light emitting region in the in-plane direction and in which current is less likely to flow than in the light emitting region. The light emitting region and the current blocking region each include a photonic crystal layer. The photonic crystal layer has a first region and second regions periodically arranged in the in-plane direction in the first region. A refractive index of each of the second regions is different from a refractive index of the first region. The light emitting region includes a first semiconductor layer having a first conductivity type, an active layer having an optical gain, and a second semiconductor layer having a second conductivity type. The first semiconductor layer, the active layer, and the second semiconductor layer are sequentially stacked on top of one another in an emission direction of the light.

## Description

### Technical Field

The present disclosure relates to a photonic crystal surface-emitting laser and a method for manufacturing the same.

### Background Art

A photonic crystal surface-emitting laser (PCSEL) in which a photonic crystal and an active layer having an optical gain are stacked is used (for example, PTL 1). The photonic crystal functions as a diffraction grating to reflect and diffract light. The light oscillates at a reflection wavelength of the photonic crystal, and the light is emitted in a vertical direction of a surface. Since a resonator is developed within a plane, the PCSEL is superior to an edge-emitting laser in terms of single mode operation and high power output.

### Citation List

### Patent Literature

PTL 1: Japanese Unexamined Patent Application Publication No. 2007-258262

### Summary of Invention

A photonic crystal surface-emitting laser according to the present disclosure includes a light emitting region from which light is emitted in a direction crossing an in-plane direction, and a current blocking region that is adjacent to the light emitting region in the in-plane direction and in which current is less likely to flow than in the light emitting region. The light emitting region and the current blocking region each include a photonic crystal layer. The photonic crystal layer has a first region and second regions periodically arranged in the in-plane direction in the first region. A refractive index of each of the second regions is different from a refractive index of the first region. The light emitting region includes a first semiconductor layer having a first conductivity type, an active layer having an optical gain, and a second semiconductor layer having a second conductivity type. The first semiconductor layer, the active layer, and the second semiconductor layer are sequentially stacked on top of one another in an emission direction of the light.

A method for manufacturing a photonic crystal surface-emitting laser according to the present disclosure includes forming a light emitting region from which light is emitted in a direction crossing an in-plane direction, and forming a current blocking region that is adjacent to the light emitting region in the in-plane direction and in which current is less likely to flow than in the light emitting region. The forming the light emitting region and the forming the current blocking region each include providing a photonic crystal layer. The photonic crystal layer has a first region and second regions periodically arranged in the in-plane direction in the first region. A refractive index of each of the second regions is different from a refractive index of the first region. In the forming the light emitting region includes sequentially stacking a first semiconductor layer having a first conductivity type, an active layer having an optical gain, and a second semiconductor layer having a second conductivity type on top of one another.

### Brief Description of Drawings

[FIG. 1A] FIG. 1A is a plan view illustrating a photonic crystal surface-emitting laser according to a first embodiment.
[FIG. 1B] FIG. 1B is a cross-sectional view taken along line A-A in FIG. 1A.
[FIG. 2A] FIG. 2A is a plan view illustrating a method for manufacturing a photonic crystal surface-emitting laser.
[FIG. 2B] FIG. 2B is a cross-sectional view taken along line A-A in FIG. 2A.
[FIG. 3A] FIG. 3A is a plan view illustrating a method for manufacturing a photonic crystal surface-emitting laser.
[FIG. 3B] FIG. 3B is a cross-sectional view taken along line A-A in FIG. 3A.
[FIG. 4A] FIG. 4A is a plan view illustrating a method for manufacturing a photonic crystal surface-emitting laser.
[FIG. 4B] FIG. 4B is a cross-sectional view taken along line A-A in FIG. 4A.
[FIG. 5A] FIG. 5A is a plan view illustrating a method for manufacturing a photonic crystal surface-emitting laser.
[FIG. 5B] FIG. 5B is a cross-sectional view taken along line A-A in FIG. 5A.
[FIG. 6A] FIG. 6A is a plan view illustrating a method for manufacturing a photonic crystal surface-emitting laser.
[FIG. 6B] FIG. 6B is a cross-sectional view taken along line A-A in FIG. 6A.
[FIG. 7A] FIG. 7A is a plan view illustrating a method for manufacturing a photonic crystal surface-emitting laser.
[FIG. 7B] FIG. 7B is a cross-sectional view taken along line A-A in FIG. 7A.
[FIG. 8A] FIG. 8A is a plan view illustrating a method for manufacturing a photonic crystal surface-emitting laser.
[FIG. 8B] FIG. 8B is a cross-sectional view taken along line A-A in FIG. 8A.
[FIG. 9A] FIG. 9A is a plan view illustrating a method for manufacturing a photonic crystal surface-emitting laser.
[FIG. 9B] FIG. 9B is a cross-sectional view taken along line A-A in FIG. 9A.
[FIG. 10A] FIG. 10A is a plan view illustrating a method for manufacturing a photonic crystal surface-emitting laser.
[FIG. 10B] FIG. 10B is a cross-sectional view taken along line A-A in FIG. 10A.
[FIG. 11A] FIG. 11A is a plan view illustrating a method for manufacturing a photonic crystal surface-emitting laser.
[FIG. 11B] FIG. 11B is a cross-sectional view taken along line A-A in FIG. 11A.
[FIG. 12A] FIG. 12A is a plan view illustrating a method for manufacturing a photonic crystal surface-emitting laser.
[FIG. 12B] FIG. 12B is a cross-sectional view taken along line A-A in FIG. 12A.
[FIG. 13] FIG. 13 is a cross-sectional view illustrating a photonic crystal surface-emitting laser according to a comparative example.
[FIG. 14] FIG. 14 is a cross-sectional view illustrating a photonic crystal surface-emitting laser according to a second embodiment.
[FIG. 15A] FIG. 15A is a plan view illustrating a method for manufacturing a photonic crystal surface-emitting laser.
[FIG. 15B] FIG. 15B is a cross-sectional view taken along line A-A in FIG. 15A.
[FIG. 16A] FIG. 16A is a plan view illustrating a method for manufacturing a photonic crystal surface-emitting laser.
[FIG. 16B] FIG. 16B is a cross-sectional view taken along line A-A in FIG. 16A.
[FIG. 17A] FIG. 17A is a plan view illustrating a photonic crystal surface-emitting laser according to a third embodiment.
[FIG. 17B] FIG. 17B is a cross-sectional view taken along line A-A in FIG. 17A.
[FIG. 18A] FIG. 18A is a cross-sectional view illustrating a method for manufacturing a photonic crystal surface-emitting laser.
[FIG. 18B] FIG. 18B is a cross-sectional view illustrating a method for manufacturing a photonic crystal surface-emitting laser.
[FIG. 19] FIG. 19 is a cross-sectional view illustrating a method for manufacturing a photonic crystal surface-emitting laser.

### Description of Embodiments

### [Problems to be solved by Present Disclosure]

Current is supplied to a PCSEL to inject carriers into an active layer, thereby generating light. For example, light is emitted from one end face of the PCSEL. Current may leak outside of a light extraction portion (light emitting region). Characteristics of the photonic crystal surface-emitting laser may be deteriorated due to the current leakage. Therefore, it is an object of the present disclosure to provide a photonic crystal surface-emitting laser and a method for manufacturing the same allowing the characteristics to be improved.

### [Advantageous effects of Present Disclosure]

According to the present disclosure, it is possible to provide a photonic crystal surface-emitting laser and a method for manufacturing the same allowing the characteristics to be improved.

### [Description of Embodiments of Present Disclosure]

First, embodiments of the present disclosure will be listed and described.

(1) An aspect of the present disclosure is a photonic crystal surface-emitting laser that includes a light emitting region from which light is emitted in a direction crossing an in-plane direction and a current blocking region that is adjacent to the light emitting region in the in-plane direction and in which current is less likely to flow than in the light emitting region. The light emitting region and the current blocking region each include a photonic crystal layer. The photonic crystal layer has a first region and second regions periodically arranged in the in-plane direction in the first region. A refractive index of each of the second regions is different from a refractive index of the first region. The light emitting region includes a first semiconductor layer having a first conductivity type, an active layer having an optical gain, and a second semiconductor layer having a second conductivity type. The first semiconductor layer, the active layer, and the second semiconductor layer are sequentially stacked on top of one another in an emission direction of the light. Current can be injected into the light emitting region. On the other hand, since current is less likely to flow in the current blocking region, current leakage from the light emitting region to the current blocking region can be suppressed. The suppression of the current leakage allows the photonic crystal surface-emitting laser to have improved characteristics.
(2) The current blocking region may include the first semiconductor layer, a third semiconductor layer having the second conductivity type, a fourth semiconductor layer having the first conductivity type, and a fifth semiconductor layer having the second conductivity type. The first semiconductor layer, the third semiconductor layer, the fourth semiconductor layer, and the fifth semiconductor layer may be sequentially stacked on top of one another in the emission direction of the light in such a manner as to form a thyristor. Since the thyristor is formed in the current blocking layer, current is less likely to flow. This can suppress the current leakage from the light emitting region to the current blocking region.
(3) The current blocking region may include a sixth semiconductor layer. The sixth semiconductor layer may be insulated. Since the current blocking region includes the sixth semiconductor layer which is insulated, current is less likely to flow in the current blocking layer. This can suppress the current leakage from the light emitting region to the current blocking region.
(4) The active layer may be included in the light emitting region and the current blocking region. This allows manufacturing process to be simplified.
(5) The current blocking region may include a seventh semiconductor layer. The seventh semiconductor layer may be adjacent to the active layer in the in-plane direction and may have a bandgap greater than an energy of light. This increases a reflectance of the current blocking region with respect to the light. By reflecting the light to the light emitting region, loss of the light can be suppressed.
(6) The current blocking region may surround a whole periphery of the light emitting region in the in-plane direction. Current leakage from the light emitting region to all directions can be suppressed.
(7) The photonic crystal surface-emitting laser further may include an eighth semiconductor layer stacked on the second semiconductor layer and having the second conductivity type, in the light emitting region. At least a portion of the current blocking region may be exposed from the eighth semiconductor layer. Current can be injected into the light emitting region through the eighth semiconductor layer. Since the eighth semiconductor layer is not provided in at least a portion of the current blocking region, parasitic capacitance can be reduced.
(8) The photonic crystal surface-emitting laser may further include a first electrode disposed on an upper surface of the eighth semiconductor layer and in the light emitting region, and a second electrode disposed on a surface of the substrate that is located on a side opposite to a side on which the first semiconductor layer is disposed. The first electrode may have a ring-like shape in the in-plane direction. The eighth semiconductor layer may be exposed at a portion of the light emitting region that is surrounded by the first electrode. Current can be injected into the light emitting region using the first electrode and the second electrode. Light can be emitted from the portion of the light emitting region that is surrounded by the first electrode.
(9) The first semiconductor layer, the photonic crystal layer, the active layer, and the second semiconductor layer may be sequentially stacked on top of one another. The photonic crystal surface-emitting laser may include a ninth semiconductor layer provided between the photonic crystal layer and the active layer and having the first conductivity type. The photonic crystal layer may have the first conductivity type. The second regions of the photonic crystal may be air holes. End portions of the air holes on the active layer side may be covered with the ninth semiconductor layer. Since the active layer is stacked on the ninth semiconductor layer, the occurrence of a depression or the like in the active layer is suppressed.
(10) A method for manufacturing a photonic crystal surface-emitting laser includes forming a light emitting region from which light is emitted in a direction crossing an in-plane direction, and forming a current blocking region that is adjacent to the light emitting region in the in-plane direction and in which current is less likely to flow than in the light emitting region. The forming the light emitting region and the forming the current blocking region each include providing a photonic crystal layer. The photonic crystal layer has a first region and second regions periodically arranged in the in-plane direction in the first region. A refractive index of each of the second regions is different from a refractive index of the first region. The forming the light emitting region includes sequentially stacking a first semiconductor layer having a first conductivity type, an active layer having an optical gain, and a second semiconductor layer having a second conductivity type on top of one another. Current can be injected into the light emitting region. On the other hand, since the current is less likely to flow in the current blocking region, current leakage from the light emitting region to the current blocking region can be suppressed. The suppression of the current leakage allows the photonic crystal surface-emitting laser to have improved characteristics.

### [Details of Embodiments of Present Disclosure]

Specific examples of a photonic crystal surface-emitting laser and a method for manufacturing the same according to embodiments of the present disclosure will be described below with reference to the drawings. It should be noted that the present disclosure is not limited to these examples, and is defined by Claims, and is intended to embrace all the modifications within the meaning and range of equivalency of the Claims.

### <First embodiment>

### (Photonic crystal surface-emitting laser)

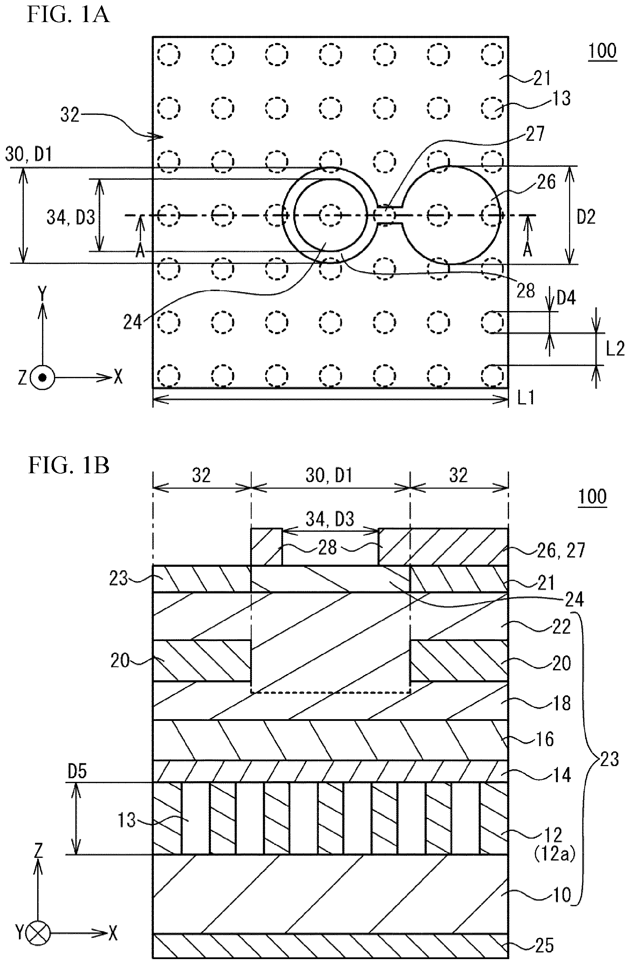

FIG. 1A is a plan view illustrating a photonic crystal surface-emitting laser 100 according to a first embodiment, and FIG. 1B is a cross-sectional view taken along line A-A in FIG. 1A. An XY-plane in the figure is a direction (in-plane direction) in which surfaces of semiconductor layers included in photonic crystal surface-emitting laser 100 extend. Photonic crystal surface-emitting laser 100 has a rectangular shape in the XY-plane. A Z-axis direction is a stacking direction of the semiconductor layers and is a direction in which light is emitted. An X-axis direction, a Y-axis direction, and the Z-axis direction are perpendicular to each other. The figures in the present description are schematic views, and dimensions, number of air holes, and the like may be changed from those illustrated in the figures.

As illustrated in FIGs. 1A and 1B, photonic crystal surface-emitting laser 100 includes a light emitting region 30 and a current blocking region 32. As illustrated in FIG. 1A, in the XY-plane, light emitting region 30 is, for example, a circular region and is located in a central portion of photonic crystal surface-emitting laser 100. Current blocking region 32 surrounds the whole periphery of light emitting region 30. Each of light emitting region 30 and current blocking region 32 is a region from an upper end to a lower end of photonic crystal surface-emitting laser 100 in the Z-axis direction.

As illustrated in FIG. 1B, in light emitting region 30, a substrate 10 (first semiconductor layer), a photonic crystal layer 12, a cladding layer 14 (ninth semiconductor layer), an active layer 16, a cladding layer 18, a cladding layer 22, and a contact layer 24 (eighth semiconductor layer) are sequentially stacked on top of one another in this order. Cladding layer 18 and cladding layer 22 are different layers from each other and are formed in separate steps as described below. Cladding layer 18 and cladding layer 22 are both p-type semiconductor layers and correspond to a second semiconductor layer. A boundary between cladding layer 18 and cladding layer 22 is indicated by a dotted line in FIG. 1B. As illustrated in FIG. 1A, contact layer 24 has a circular shape in the XY-plane and covers the whole light emitting region 30. As illustrated in FIG. 1B, an electrode 28 (first electrode) is disposed on an upper surface of contact layer 24.

In current blocking region 32, substrate 10, photonic crystal layer 12, cladding layer 14, active layer 16, cladding layer 18 (third semiconductor layer), a buried layer 20 (fourth semiconductor layer), and cladding layer 22 (fifth semiconductor layer) are sequentially stacked on top of one another in this order. Contact layer 24 is not provided in current blocking region 32. An insulating film 21 is provided on an upper surface of cladding layer 22 and covers the whole current blocking region 32 as illustrated in FIG. 1A. As illustrated in FIG. 1B, an electrode 25 (second electrode) is disposed on a lower surface of substrate 10 and extends over light emitting region 30 and current blocking region 32.

As illustrated in FIGs. 1A and 1B, a pad 26 and a wiring line 27 are disposed on an upper surface of insulating film 21. Electrode 28 and pad 26 are electrically connected to each other by wiring line 27. Electrode 28 is formed of a metal such as a laminate (Ti/Pt/Au) of titanium, platinum and gold. Wiring line 27 and pad 26 are formed of a metal such as Au. Electrode 25 is formed of a metal such as an alloy (AuGeNi) of gold, germanium and Ni.

Electrode 28 has an annular shape in the XY-plane. Any structure that blocks emitted light is not provided in a portion surrounded by electrode 28. A structure formed of a material transparent to the emitted light may be provided. A portion of light emitting region 30 surrounded by electrode 28 serves as an aperture 34. Light is emitted from aperture 34 in the Z-axis direction. Light emitting region 30 has a diameter D1 of 15 µm, for example. Aperture 34 has a diameter D3 of 10 µm, for example. Pad 26 has a diameter D2 of 50 µm, for example. Photonic crystal surface-emitting laser 100 A has a side length L1 of, for example, 500 µm in the X-axis direction. For example, a side length in the Y-axis direction may be equal to side length L1 in the X-axis direction, or may be different from the length L1.

Substrate 10 is a semiconductor substrate formed of, for example, n-type indium phosphide (n-InP). Cladding layer 14 and buried layer 20 are formed of, for example, n-InP. Cladding layer 14 has a thickness of 150 nm, for example. Buried layer 20 has a thickness of 500 nm, for example. Cladding layers 18 and 22 are formed of, for example, p-InP. A thickness of cladding layer 18 from active layer 16 to buried layer 2 is, for example, 300 nm. A thickness of cladding layer 22 in light emitting region 30 is, for example, 3 µm. Contact layer 24 is formed of, for example, 300 nm-thick p-type indium gallium arsenide (p-InGaAs). For example, silicon (Si) is used as an n-type dopant. For example, zinc (Zn) is used as a p-type dopant.

Active layer 16 includes, for example, multiple well layers and multiple barrier layers, and has a multi quantum well (MQW) structure. The well layers and the barrier layers are formed of, for example, undoped gallium indium arsenide phosphide (i-GaInAsP). When substrate 10 is formed of InP, the well layers and the barrier layers are formed of a compound semiconductor that can be lattice-matched with InP, for example, undoped indium aluminum gallium arsenide (i-InAlGaAs). Active layer 16 has spacer layers (not illustrated) between cladding layer 14 and active layer 16, and between cladding layer 18 and active layer 16. Active layer 16 including the spacer layers has a thickness of 200 nm, for example. The spacer layers may be omitted.

Photonic crystal layer 12 has a base member 12a (first region) and a plurality of air holes 13 (second regions). Base member 12a is formed of, for example, 300 nm-thick n-type indium gallium arsenide phosphide (n-InGaAsP). A bandgap wavelength of photonic crystal layer 12 is, for example, 1.1 µm, which is smaller than an oscillation wavelength of light. As illustrated in FIG. 1A, the plurality of air holes 13 are provided in base member 12a and periodically arranged in the X-axis direction and the Y-axis direction. A distance L2 between two adjacent air holes 13 is, for example, 400 nm. Each of air holes 13 has a diameter D4 of 100 nm, for example.

Each of air holes 13 illustrated in FIG. 1B has a depth D5 of 100 nm to 2000 nm, for example. Air holes 13 extend from a lower surface of cladding layer 14 to a lower surface of photonic crystal layer 12 in the Z-axis direction. The inside of air holes 13 is hollow and filled with gas. A refractive index of InGaAsP, which is the base member of photonic crystal layer 12, is different from refractive indices of air holes 13. In other words, a refractive index of photonic crystal layer 12 periodically changes in the XY-plane. Light is reflected and refracted in a plane of photonic crystal layer 12 and oscillates at a wavelength depending on an arrangement of air holes 13.

In light emitting region 30 illustrated in FIG. 1B, substrate 10, photonic crystal layer 12, and cladding layer 14 are n-type semiconductor layers and are located below active layer 16 in the Z-axis direction. Cladding layers 18 and 22 are p-type semiconductor layers and are located above active layer 16. In light emitting region 30, a p-i-n (positive-intrinsic-negative) structure is formed in the Z-axis direction. Since light emitting region 30 has the p-i-n structure, a current easily flows in the Z-axis direction. Current is supplied to light emitting region 30 to inject carriers into active layer 16, thereby generating light. The light emitted from photonic crystal surface-emitting laser 100 has a spot diameter that depends on a diameter of light emitting region 30.

In current blocking region 32, substrate 10, photonic crystal layer 12, and cladding layer 14 are n-type semiconductor layers and are located below active layer 16. P-type cladding layer 18, n-type buried layer 20, and p-type cladding layer 22 are sequentially stacked on top of one another in this order above active layer 16. In other words, in current blocking region 32, n-type layers and p-type layers are alternately stacked in the Z-axis direction to form a thyristor 23. Due to the presence of thyristor 23, current is less likely to flow in current blocking region 32 than in light emitting region 30.

Current is input using electrodes 25 and 28, so that the current can flow in light emitting region 30 in the Z-axis direction to inject carriers into active layer 16. The injection of carriers causes active layer 16 to generate light.

Since the plurality of air holes 13 are provided in photonic crystal layer 12, light is reflected and diffracted in the XY-plane. Light having a specific wavelength such as 1.3 µm is amplified in correspondence with a period of the plurality of air holes 13. Since electrode 25 functions as a mirror for reflecting light, light propagating in a downward direction in FIG. 1B is not emitted from a lower surface but is reflected and propagates in an upward direction. A portion of light emitting region 30 surrounded by electrode 28 functions as aperture 34. Light is emitted from the inside of aperture 34 to the outside (upward) of photonic crystal surface-emitting laser 100. An intensity of the light can be modulated by repeatedly turning the current on and off. A frequency of the modulation is, for example, several tens of GHz such as 25 GHz or 50 GHz.

As described above, since thyristor 23 is formed in current blocking region 32, current is less likely to flow in current blocking region 32. On the other hand, since light emitting region 30 has a p-i-n structure in the Z-axis direction, current easily flows in light emitting region 30. Current can be selectively input to light emitting region 30 to suppress current leakage to current blocking region 32. The suppression of leakage allows photonic crystal surface-emitting laser 100 to have improved characteristics.

### (Method for manufacturing)

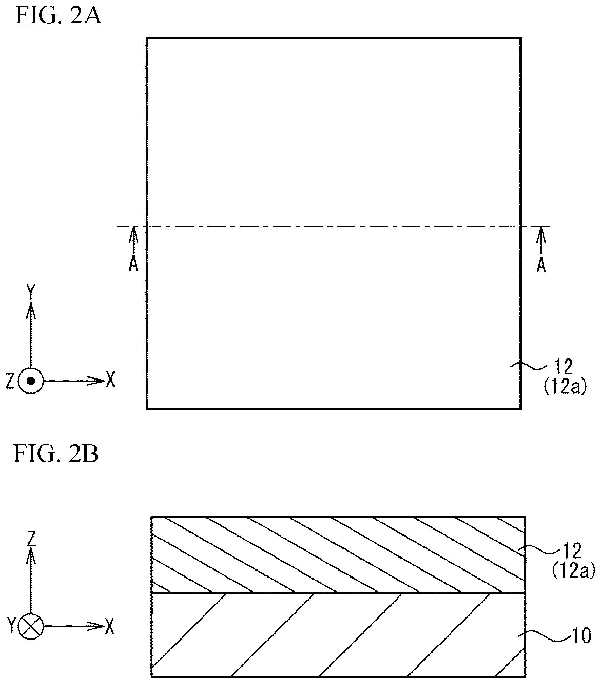

FIG. 2A, FIG. 3A, FIG. 4A, FIG. 5A, FIG. 6A, FIG. 7A, FIG. 8A, FIG. 9A, FIG. 10A, FIG. 11A, and FIG. 12A are plan views illustrating a method for manufacturing photonic crystal surface-emitting laser 100. FIG. 2B, FIG. 3B, FIG. 4B, FIG. 5B, FIG. 6B, FIG. 7B, FIG. 8B, FIG. 9B, FIG. 10B, FIG. 11B, and FIG. 12B are cross-sectional views taken along lines A-A in the corresponding plan views.

As illustrated in FIGs. 2A and 2B, photonic crystal layer 12 is epitaxially grown on an upper surface of substrate 10 by, for example, metal-organic vapor phase epitaxy (MOVPE). In this step, air holes 13 are not formed.

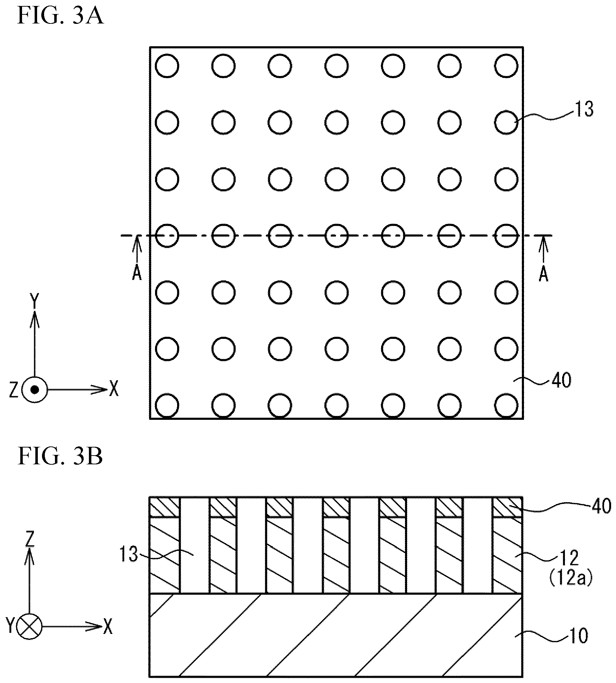

As illustrated in FIGs. 3A and 3B, an insulating film 40 of silicon oxide (SiO₂) is formed on an upper surface of photonic crystal layer 12 by, for example, a plasma chemical vapor deposition (CVD) method. A photoresist is applied to an upper surface of insulating film 40, and patterning is performed by lithography using an electron beam or the like. A resist pattern is transferred to insulating film 40 by dry etching or the like. The transferred pattern corresponds to the plurality of air holes 13. Dry etching is performed using insulating film 40 as a mask to form the plurality of air holes 13 in photonic crystal layer 12. The arrangement of the plurality of air holes 13 can be adjusted based on a wavelength or the like of light. For example, an arrangement corresponding to an oscillation wavelength of 1.3 µm is adopted. As an etching gas, a gas that can process InP and InGaAsP, such as (CH₃), silicon tetrachloride (SiCl₄), chlorine (Ch), or hydrogen iodide (HI), is used. After air holes 13 are formed, insulating film 40 is removed.

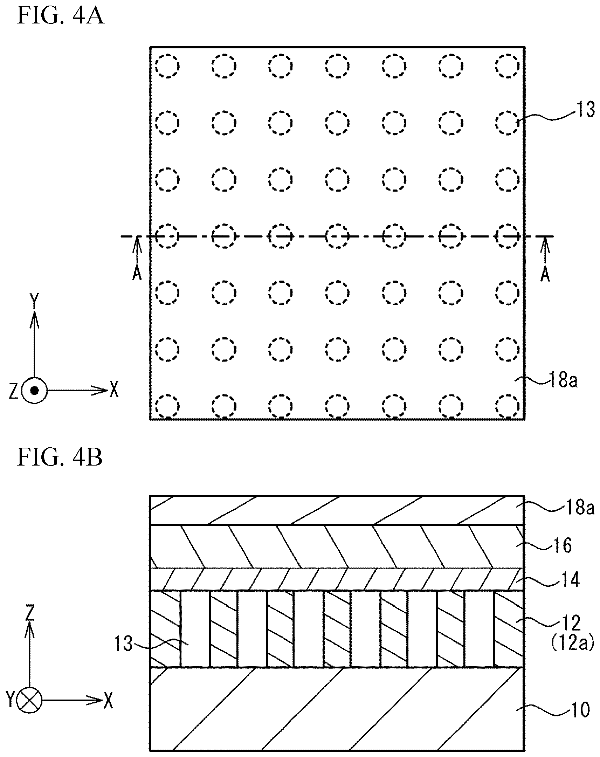

As illustrated in FIGs. 4A and 4B, cladding layer 14, active layer 16, and a cladding layer 18a are sequentially grown on top of one another on the upper surface of photonic crystal layer 12. Cladding layer 14 is, for example, a 150 nm-thick n-InP layer. Cladding layer 14 is provided on air holes 13 to make air holes 13 closed spaces that do not communicate with the outer space. An upper surface of cladding layer 14 is flat. Active layer 16 and cladding layer 18a are epitaxially grown on the upper surface of cladding layer 14. Cladding layer 18a is, for example, a 200 nm-thick p-InP layer.

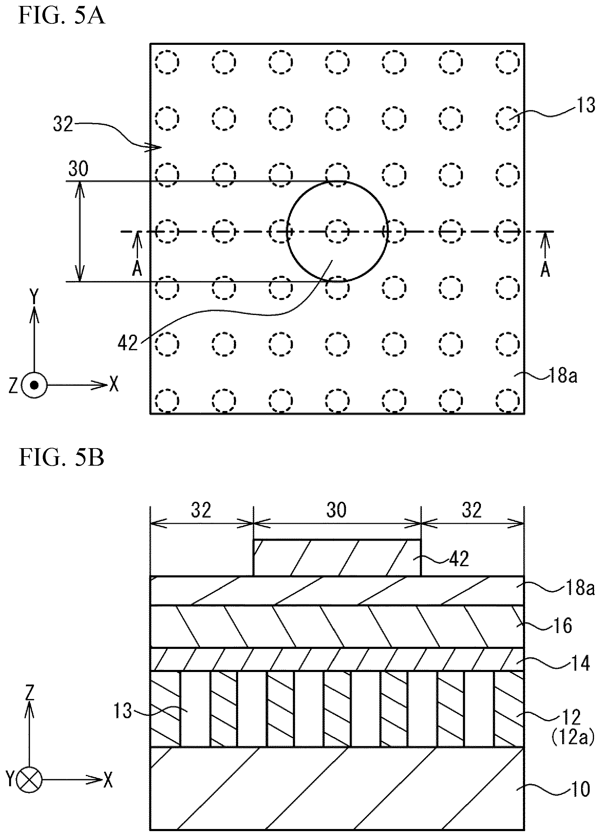

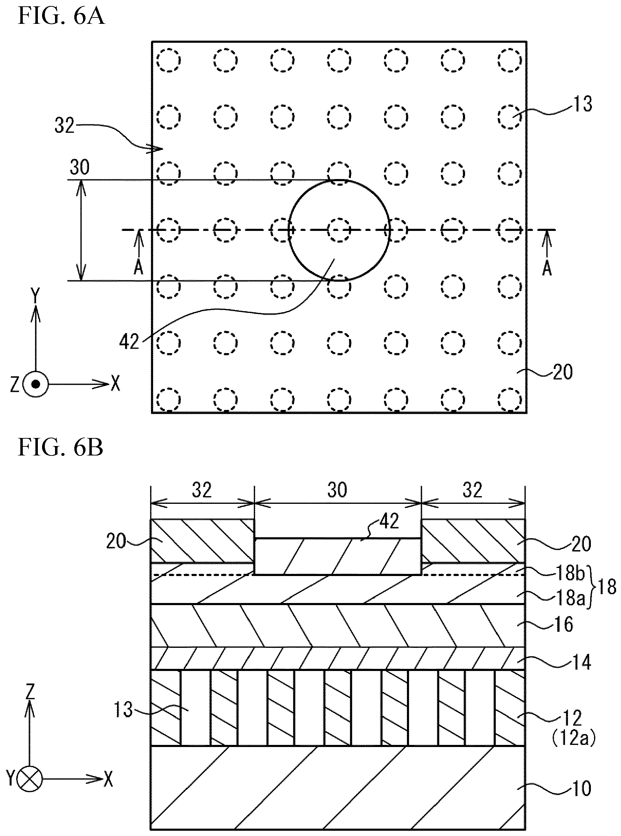

As illustrated in FIGs. 5A and 5B, an insulating film 42 is formed on an upper surface of cladding layer 18a by, for example, a plasma CVD method or the like, and is processed into a circular shape having a diameter of 15 µm by photolithography, dry etching and the like. Insulating film 42 is, for example, a 300 nm-thick SiO₂ film, and is located at a central portion of the upper surface of cladding layer 18a. A portion covered with insulating film 42 serves as light emitting region 30, and a portion outside insulating film 42 serves as current blocking region 32. As illustrated in FIGs. 6A and 6B, insulating film 42 functions as a selective growth mask.

As illustrated in FIGs. 6A and 6B, a cladding layer 18b and buried layer 20 are epitaxially grown on top of each other in order at a portion of the upper surface of cladding layer 18a that is not covered with insulating film 42. Cladding layer 18b is, for example, a 300 nm-thick p-InP layer and forms cladding layer 18 together with cladding layer 18a. Cladding layer 18b and buried layer 20 are not grown on a portion of the upper surface of cladding layer 18a that is covered with insulating film 42.

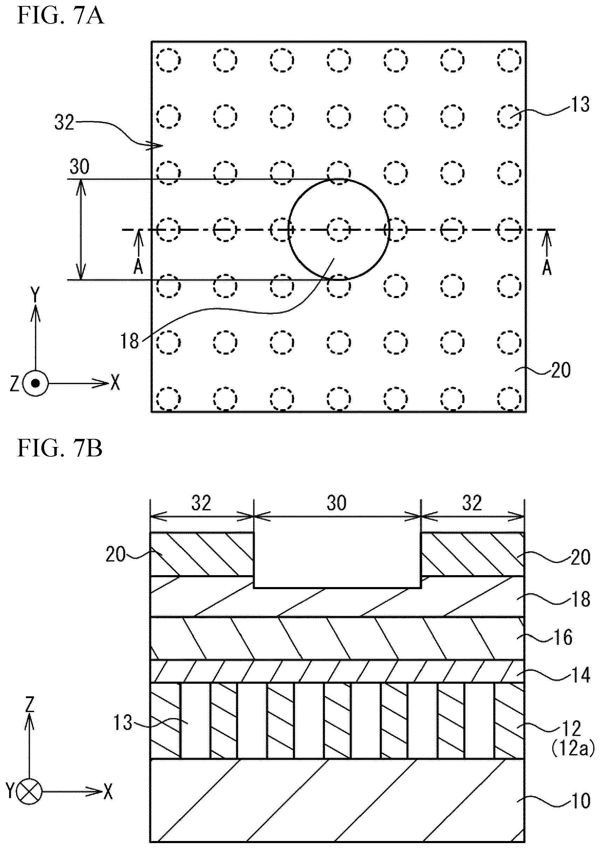

As illustrated in FIGs. 7A and 7B, insulating film 42 is removed. An upper surface of cladding layer 18 is exposed in light emitting region 30.

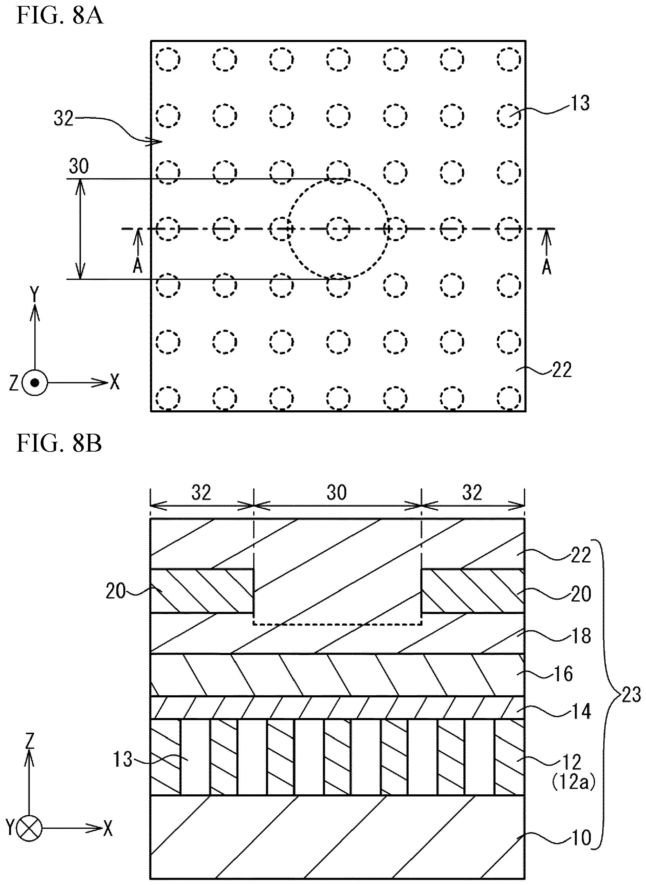

As illustrated in FIGs. 8A and 8B, cladding layer 22 is epitaxially grown on the upper surface of cladding layer 18 in light emitting region 30 and an upper surface of buried layer 20 in current blocking region 32 by, for example, an MOPVE method. As illustrated in FIG. 8B, a step between cladding layer 18 and buried layer 20 is filled with cladding layer 22 to make the upper surface of cladding layer 22 flat. In current blocking region 32, n-type substrate 10, n-type photonic crystal layer 12, n-type cladding layer 14, p-type cladding layer 18, n-type buried layer 20, and p-type cladding layer 22 are stacked to form thyristor 23. In light emitting region 30, n-type substrate 10, n-type photonic crystal layer 12, n-type cladding layer 14, active layer 16 having an MQW structure, p-type cladding layer 18, and p-type cladding layer 22 are stacked to form the p-i-n structure.

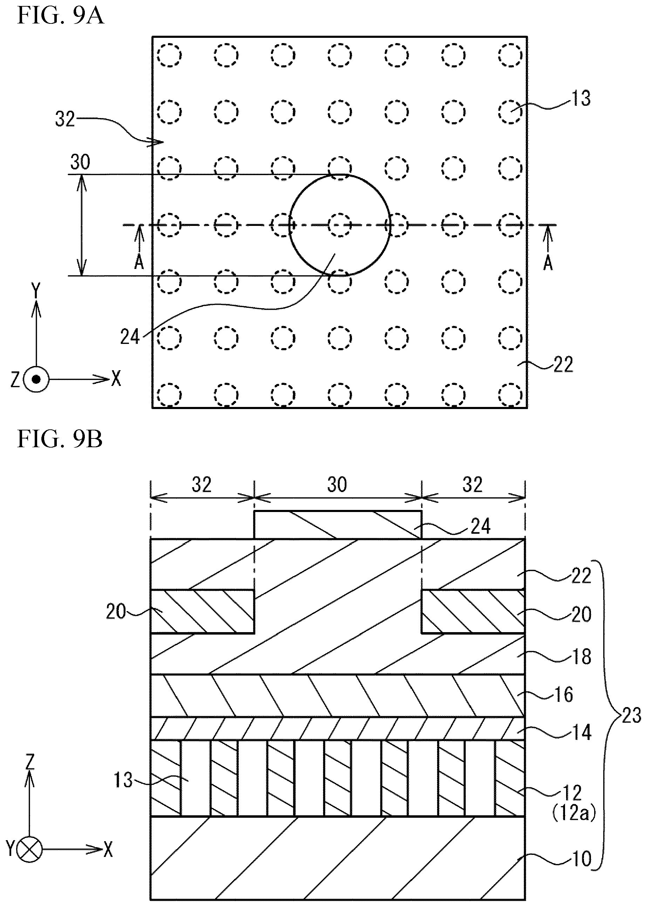

As illustrated in FIGs. 9A and 9B, contact layer 24 is epitaxially grown on the upper surface of cladding layer 22 by, for example, the MOVPE method or the like. A resist pattern (not illustrated) is formed by photolithography, and wet etching is performed, so that contact layer 24 is removed from current blocking region 32. Contact layer 24 having a circular shape remains in light emitting region 30.

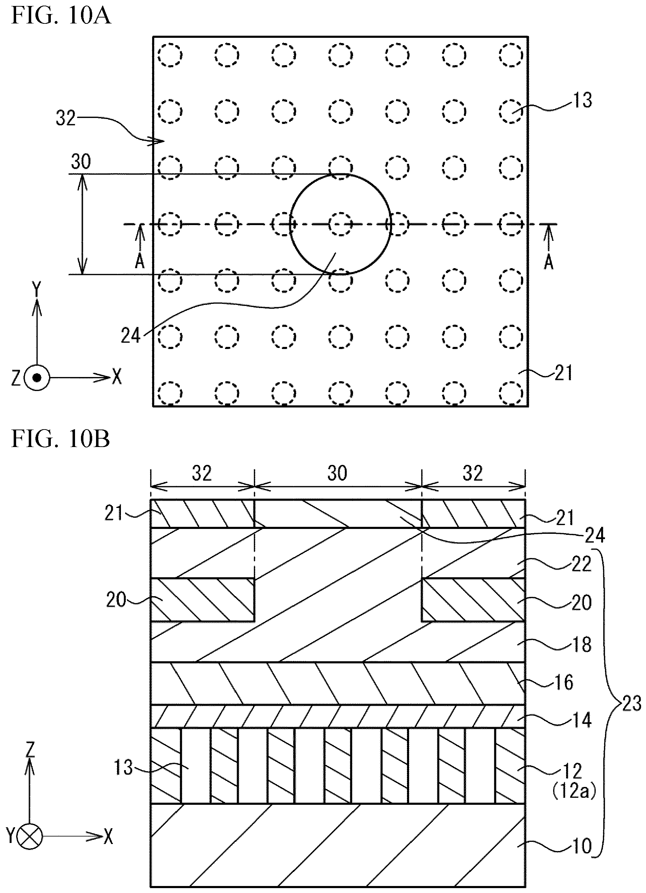

As illustrated in FIGs. 10A and 10B, insulating film 21 is formed by, for example, the plasma CVD method, and insulating film 21 is removed from an upper surface of contact layer 24 by etching or the like. In light emitting region 30, contact layer 24 is exposed. Insulating film 21 remains in current blocking region 32.

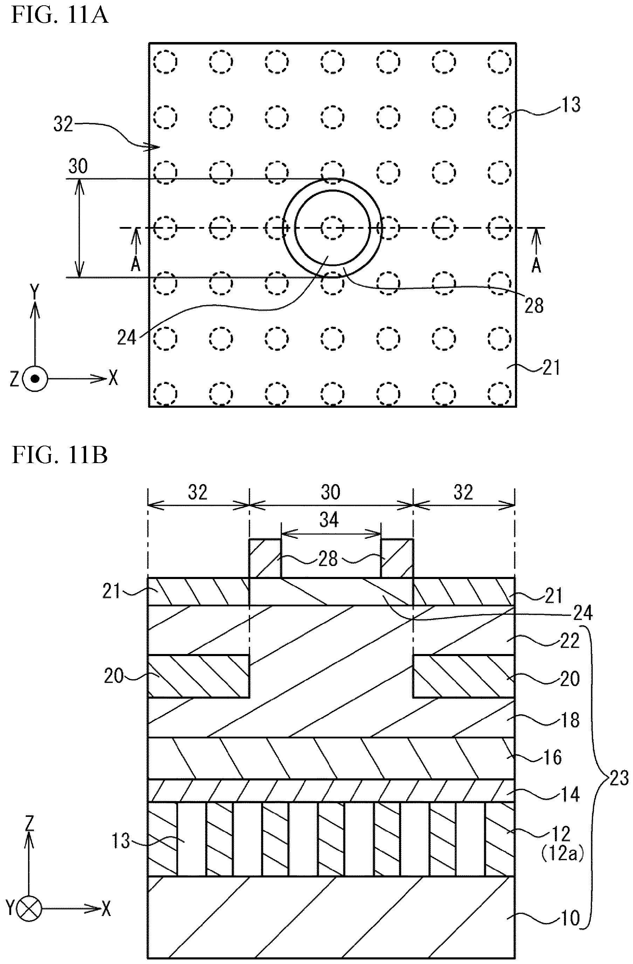

As illustrated in FIGs. 11A and 11B, electrode 28 is formed on the upper surface of contact layer 24 by, for example, vacuum deposition, lift-off and the like. Electrode 28 has an annular shape, and contact layer 24 is exposed in the portion surrounded by electrode 28. The exposed portion of contact layer 24 serves as aperture 34.

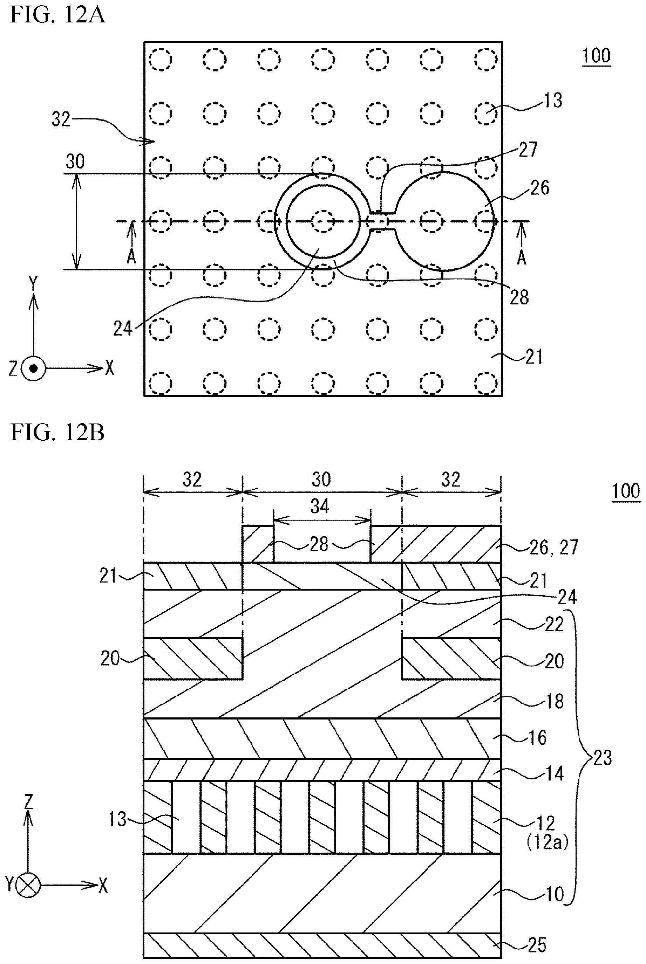

As illustrated in FIGs. 12A and 12B, pad 26, wiring line 27, and electrode 25 are formed by vacuum deposition, lift-off, and the like. Specifically, the lower surface of substrate 10 is mirror-finished by polishing, and then electrode 25 is disposed on the whole lower surface. Pad 26 and wiring line 27 are disposed on the upper surface of insulating film 21. Through the above steps, photonic crystal surface-emitting laser 100 is formed.

### (Comparative example)

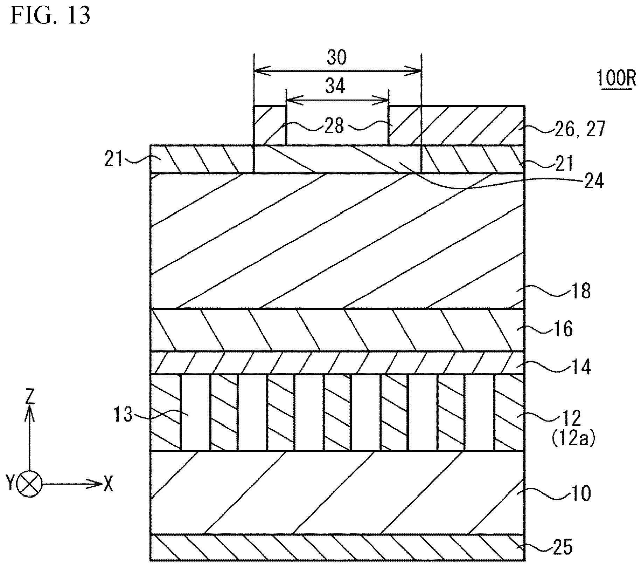

FIG. 13 is a cross-sectional view illustrating a photonic crystal surface-emitting laser 100R according to a comparative example. As illustrated in FIG. 13, cladding layer 18 is provided on active layer 16, and contact layer 24 and insulating film 21 are provided on an upper surface of cladding layer 18. Buried layer 20 and cladding layer 22 are not provided, so that a thyristor is not formed. N-type layers (substrate 10, photonic crystal layer 12, and cladding layer 14), active layer 16, and p-type cladding layer 18 form a p-i-n structure in the whole photonic crystal surface-emitting laser 100R.

Current flows through p-type contact layer 24 and cladding layer 18 and is injected into active layer 16. The current diffuses in the XY-plane in cladding layer 18 and leaks to the outside of light emitting region 30. Such leakage current is less likely to contribute to generation of light extracted from aperture 34. The current leakage may cause deterioration in characteristics such as deterioration in threshold current and reduction in optical power. In particular, when photonic crystal surface-emitting laser 100R is miniaturized, the influence of the leakage current becomes large. In order to modulate light at a frequency such as 25 GHz, a diameter of light emitting region 30 is set to 10 µm to 20 µm, for example. Current leaks to a portion having a length of about 20 µm to 30 µm from light emitting region 30 outward in a radial direction. Since the portion to which the current leaks has a size similar to a size of light emitting region 30, the influence of the current leakage on the characteristics becomes large.

According to the first embodiment, in light emitting region 30, n-type substrate 10, n-type photonic crystal layer 12, and n-type cladding layer 14 are stacked below active layer 16. P-type cladding layers 18 and 22 are stacked above active layer 16. Since light emitting region 30 has the p-i-n structure in the Z-axis direction, current can be injected into active layer 16.

In current blocking region 32, n-type substrate 10, n-type photonic crystal layer 12, n-type cladding layer 14, p-type cladding layer 18, n-type buried layer 20, and p-type cladding layer 22 are sequentially stacked on top of one another. N-type layers and p-type layers are alternately stacked in the Z-axis direction, so that thyristor 23 is formed in current blocking region 32. Current is less likely to flow in current blocking region 32 having thyristor 23 than in light emitting region 30. Current leakage from light emitting region 30 to current blocking region 32 is suppressed, and current is concentrated and flows in light emitting region 30. Characteristics of photonic crystal surface-emitting laser 100 can be improved.

For example, diameter D1 of light emitting region 30 illustrated in FIG. 1A is set to 15 to 20 µm, and diameter D3 of aperture 34 is set to 10 µm. In the comparative example in FIG. 13, a threshold current is 12 mA. An optical power is 1.5 mW when a current of 30 mA is input. According to the first embodiment, a threshold current is 3 mA, which is lower than in the comparative example. When a current of 30 mA is input, an optical power is 4 mW, which is more than in the comparative example. As described above, characteristics such as the threshold current and the optical power can be improved. Setting diameters D1 and D3 to the sizes described above and suppressing current leakage enable photonic crystal surface-emitting laser 100 to have a reduced spot diameter of emitted light and also a high efficiency. Reducing the diameter of light emitting region 30 allows light to be modulated at a frequency of 10 GHz or higher, for example, 25 GHz or 50 GHz.

In light emitting region 30, p-type layers, an undoped layer (i), and n-type layers are arranged from an upper side to a lower side in the Z-axis direction in FIG. 1B. In current blocking region 32, layers are stacked in the order of pnpn. The order of p-type layer and n-type layer may be reversed. Semiconductor layers included in photonic crystal surface-emitting laser 100 may be formed of, for example, compound semiconductors such as GaAs-based semiconductors in addition to the materials described above.

As illustrated in FIG. 1B, active layer 16 is included in light emitting region 30 and current blocking region 32. As illustrated in FIG. 4B, since active layer 16 is stacked on both regions simultaneously, the process is simplified and the cost is reduced.

As illustrated in FIGs. 1A and 1B, since light emitting region 30 and current blocking region 32 are adjacent to each other, current leakage from light emitting region 30 to the outside can be suppressed. As illustrated in FIG. 1A, current blocking region 32 preferably surrounds a periphery of light emitting region 30 and more preferably, completely surrounds the whole periphery of light emitting region 30. In the XY-plane, current leakage from light emitting region 30 in all directions can be suppressed. Characteristics can be effectively improved.

Contact layer 24 is provided in light emitting region 30 of the upper surface of cladding layer 22. Contact layer 24 is not provided in current blocking region 32, and an upper surface of current blocking region 32 is exposed. Since contact layer 24 has a lower resistance than the other semiconductor layers, an electric field is applied to the whole contact layer 24. When contact layer 24 is provided on the whole upper surface of cladding layer 22, an electric field is applied not only to light emitting region 30 but also to current blocking region 32, thereby increasing parasitic capacitance. By not providing contact layer 24 in current blocking region 32 as illustrated in FIG. 1B, parasitic capacitance can be reduced. This is advantageous for high-speed modulation. Although contact layer 24 may be provided in a portion of current blocking region 32, it is preferable that at least a portion of current blocking region 32 is exposed from contact layer 24 in order to reduce parasitic capacitance. In order to reduce electrical resistance, contact layer 24 preferably covers the whole light emitting region 30.

As illustrated in FIG. 1A, in the XY-plane, light emitting region 30 has a circular shape, and electrode 28 has an annular shape. Light emitting region 30 may have any of a circular shape, an elliptical shape, and a polygonal shape in the XY-plane. Electrode 28 may have an outer shape of an oval, an elliptical shape or the like as long as it is a ring-like shape. The portion surrounded by electrode 28 serves as aperture 34, and light can be emitted without loss due to electrode 28. Electrode 28 only needs to be in contact with a portion of contact layer 24. A dopant concentration of contact layer 24 is higher than dopant concentrations of the other semiconductor layers, and thus contact layer 24 has a high conductivity. When current is supplied to electrode 28, current flows through the whole contact layer 24 and is input to active layer 16. An interface between substrate 10 and electrode 25 preferably functions as a mirror. Light propagating downward in the Z-axis direction is reflected upward, thereby suppressing light loss.

An aperture may be formed on the lower surface of substrate 10 and light may be emitted from the lower surface. For example, electrode 25 has a ring-like shape, and a portion surrounded by electrode 25 serves as the aperture. In order to reflect light downward, it is preferable that a light reflectance at an interface between electrode 28 and contact layer 24 is high.

Photonic crystal layer 12 is an n-type layer and is provided between active layer 16 and substrate 10. Substrate 10, photonic crystal layer 12 and cladding layer 14 are, as n-type layers, parts of the p-i-n structure and thyristor 23.

As illustrated in FIG. 1B, the plurality of air holes 13 extend in photonic crystal layer 12. End portions of air holes 13 on an upper side in the Z-axis direction are filled with cladding layer 14. In other words, a flat surface of cladding layer 14 is disposed on air holes 13. Active layer 16 is grown on an upper surface of cladding layer 14, and cladding layers 18 and 22, buried layer 20, and contact layer 24 are grown above active layer 16. Since cladding layer 14 closes the top of air holes 13, crystal growth is hardly affected by air holes 13. Generation of depressions or the like is suppressed, and semiconductor layers having high crystallinity can be grown.

Photonic crystal layer 12 may be a p-type layer and may be provided between active layer 16 and cladding layer 18. Photonic crystal layer 12 and cladding layer 18 are, as p-type layers, parts of the p-i-n structure and thyristor 23.

As illustrated in FIGs. 1A and 1B, the plurality of air holes 13 are provided in both light emitting region 30 and current blocking region 32. Light is repeatedly diffracted and reflected in the whole XY-plane of photonic crystal surface-emitting laser 100 to amplify light having a specific oscillation wavelength such as 1.3 µm. Photonic crystal layer 12 may have regions each having a refractive index different from a refractive index of a base member in place of air holes 13. For example, photonic crystal layer 12 may have a semiconductor (such as InGaAsP) of the base member and regions of a semiconductor different from the base member.

### <Second embodiment>

### (Photonic crystal surface-emitting laser)

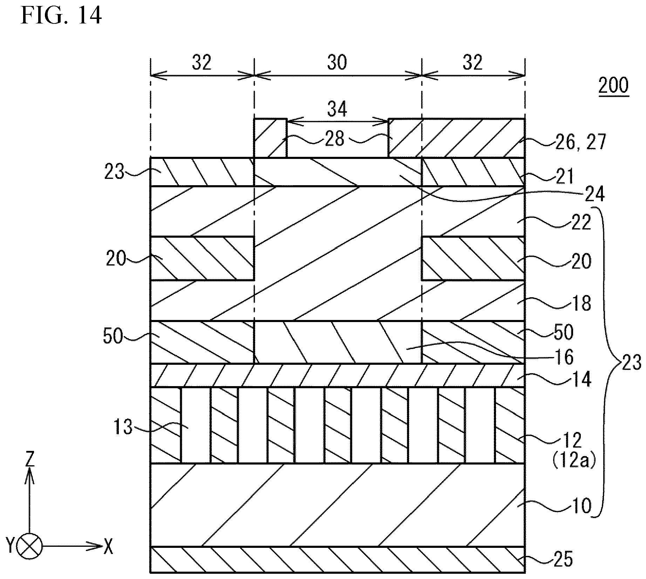

FIG. 14 is a cross-sectional view illustrating a photonic crystal surface-emitting laser 200 according to a second embodiment. Description of the same configuration as in the first embodiment will be omitted. A plan view is the same as in FIG. 1A.

As illustrated in FIG. 14, active layer 16 is not provided between cladding layer 14 and cladding layer 18 in current blocking region 32, and a passive layer 50 (seventh semiconductor layer) is provided. Passive layer 50 is adjacent to active layer 16 in the XY-plane and surrounds the whole periphery of active layer 16. Passive layer 50 is formed of a mixed crystal semiconductor such as InGaAsP and does not have an optical gain. A thickness of passive layer 50 may be equal to or different from a thickness of active layer 16, for example. An equivalent refractive index of passive layer 50 may be equal to or different from an equivalent refractive index of active layer 16, for example. For example, it is sufficient that there is no adverse optical effect such as a decrease in reflectance. A photoluminescence (PL) wavelength of passive layer 50 is smaller than a wavelength at which a gain of active layer 16 reaches a peak by 50 nm or more. For this reason, passive layer 50 is less likely to absorb light.

### (Method for manufacturing)

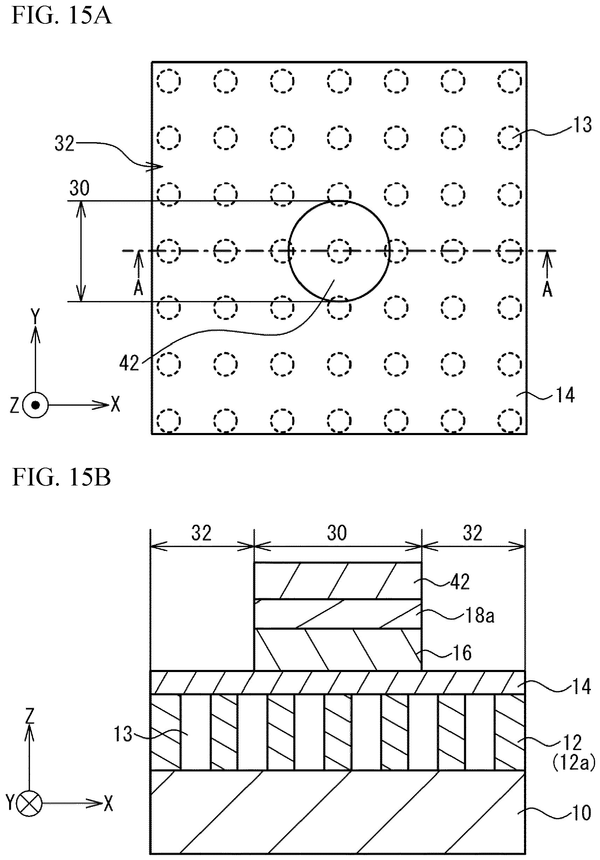

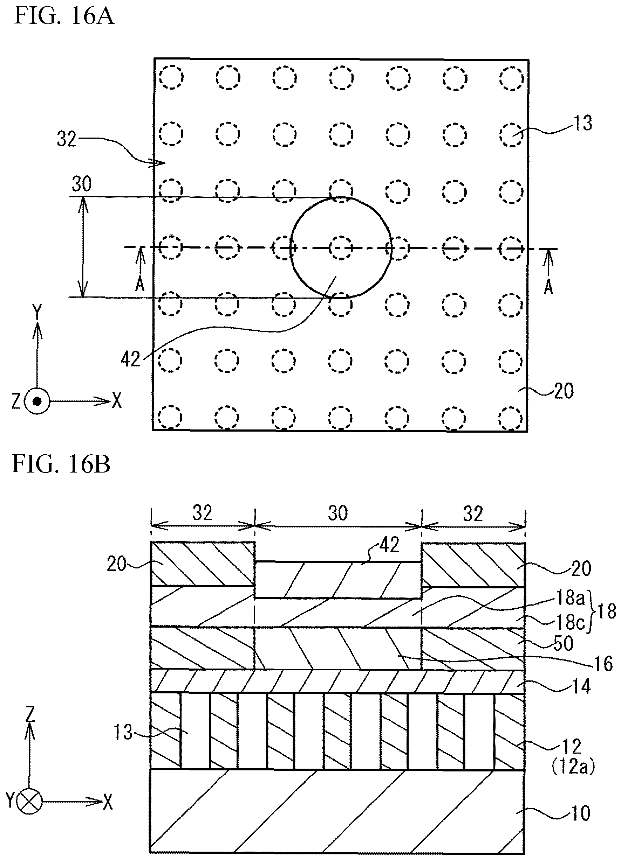

FIGs. 15A and 16A are plan views illustrating a method for manufacturing photonic crystal surface-emitting laser 200. FIGs. 15B and 16B are cross-sectional views along line A-A of the corresponding plan views. The steps illustrated in FIGs. 3A to 5B are common to those in the second embodiment.

As illustrated in FIGs. 15A and 15B, insulating film 42 is provided at a central portion of the upper surface of cladding layer 18a. Using insulating film 42 as a mask, dry etching, wet etching, and the like are performed to remove portions of cladding layer 18a and active layer 16 that are not covered with insulating film 42. After etching, a portion of the upper surface of cladding layer 14 that is included in current blocking region 32 is exposed. A portion covered with insulating film 42 is not etched.

As illustrated in FIGs. 16A and 16B, passive layer 50, a cladding layer 18c, and buried layer 20 are epitaxially grown in this order on top of one another on the upper surface of cladding layer 14 by, for example, the MOVPE method. Passive layer 50 surrounds active layer 16. Cladding layer 18c forms cladding layer 18 together with cladding layer 18a remaining in light emitting region 30. The subsequent steps are the same as those illustrated in FIGs. 7A to 12B.

According to the second embodiment, since the p-i-n structure including active layer 16 is formed in light emitting region 30, current can be injected into active layer 16. Since thyristor 23 is formed in current blocking region 32, current is less likely to flow in current blocking region 32 than in light emitting region 30. Since current leakage from light emitting region 30 to current blocking region 32 is suppressed, characteristics of photonic crystal surface-emitting laser 200 can be improved.

Passive layer 50 is provided in current blocking region 32 in the second embodiment. Therefore, a light reflectance of current blocking region 32 is higher than a light reflectance of current blocking region 32 in the first embodiment, so that characteristics can be improved. An effective optical loss of a portion outside aperture 34 (current blocking region 32) in the first embodiment is 240 cm⁻¹, and a light reflectance is about 86%. On the other hand, an effective optical loss in current blocking region 32 in the second embodiment is 15 cm⁻¹, and a reflectance is 97%. Most of light which is incident on current blocking region 32 from light emitting region 30 is reflected toward light emitting region 30, so that light loss can be suppressed. According to the second embodiment, a threshold current can be reduced to 1.5 mA. When a current of 30 mA is input, an optical power of 7 mW is obtained. As described above, the threshold current and the optical power can be further improved.

### <Third embodiment>

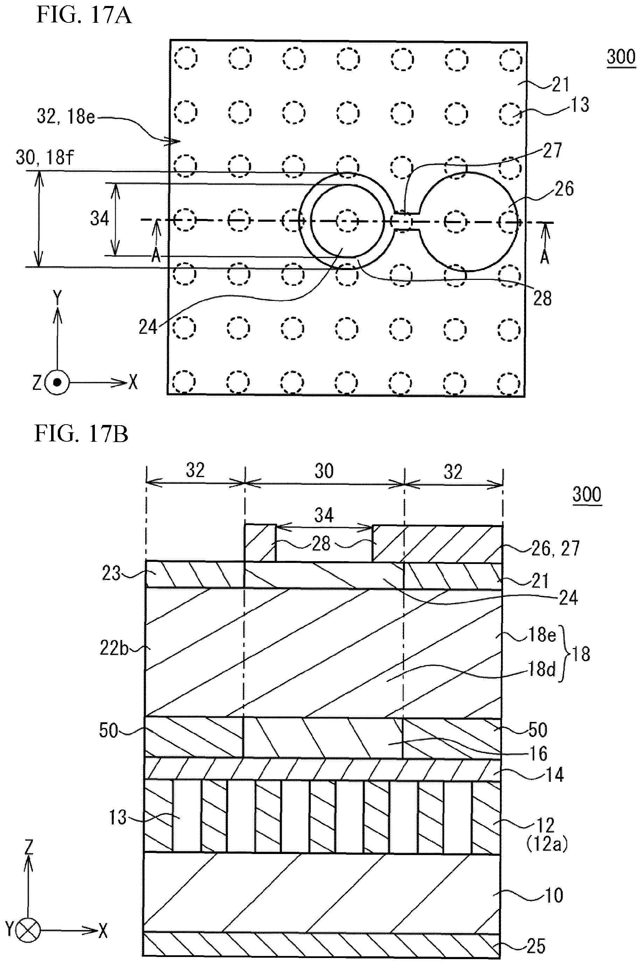

FIG. 17A is a plan view illustrating a photonic crystal surface-emitting laser 300 according to a third embodiment, and FIG. 17B is a cross-sectional view taken along line A-A in FIG. 17A. Description of the same configuration as in the first embodiment and the same configuration as in the second embodiment will be omitted.

As illustrated in FIG. 17B, in light emitting region 30, active layer 16 and cladding layer 18 are sequentially stacked on top of each other on the upper surface of cladding layer 14. Contact layer 24 is provided on the upper surface of cladding layer 18. In current blocking region 32, passive layer 50 and cladding layer 18 are sequentially stacked on top of each other on the upper surface of cladding layer 14. Insulating film 21 is provided on the upper surface of cladding layer 18. Cladding layer 18 is formed of, for example, InP having a thickness of about 3.2 µm. Buried layer 20 and cladding layer 22 are not provided. No thyristor is formed in current blocking region 32.

As illustrated in FIGs. 17A and 17B, a portion of cladding layer 18 within light emitting region 30 is referred to as a region 18d (second semiconductor layer), and a portion of cladding layer 18 within current blocking region 32 is referred to as a region 18e (sixth semiconductor layer). Region 18e surrounds the whole periphery of region 18d. As described below, region 18d has a p-type conductivity. Region 18e is a region which is insulated by ion implantation.

### (Method for manufacturing)

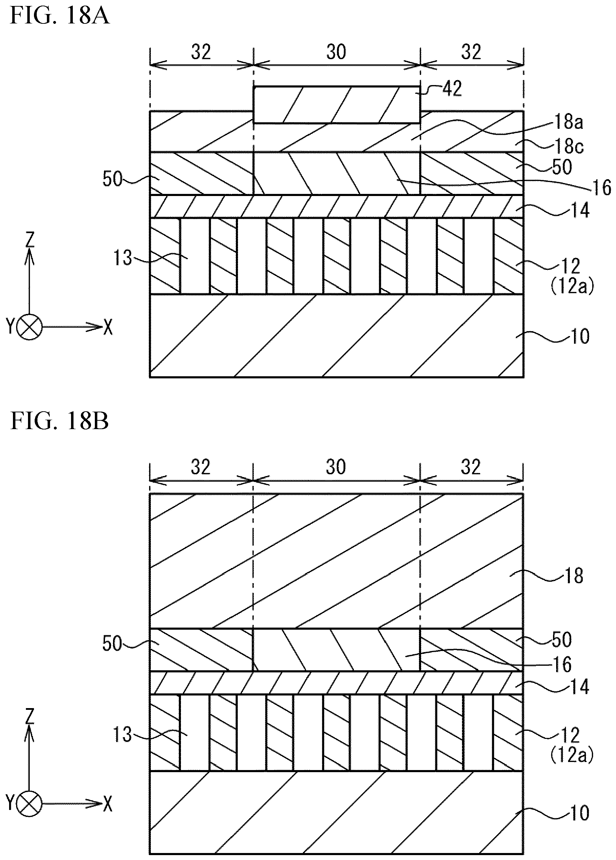

FIGs. 18A to 19 are cross-sectional views illustrating a method for manufacturing photonic crystal surface-emitting laser 300. The steps illustrated in FIGs. 2A to 5B of the first embodiment and the steps illustrated in FIGs. 15A and 15B of the second embodiment are also performed in the third embodiment.

As illustrated in FIG. 18A, cladding layer 18c is epitaxially grown on an upper surface of passive layer 50. Buried layer 20 is not provided. As illustrated in FIG. 18B, insulating film 42 used as a selective growth mask is removed. A p-InP layer is grown on cladding layer 18c to form cladding layer 18.

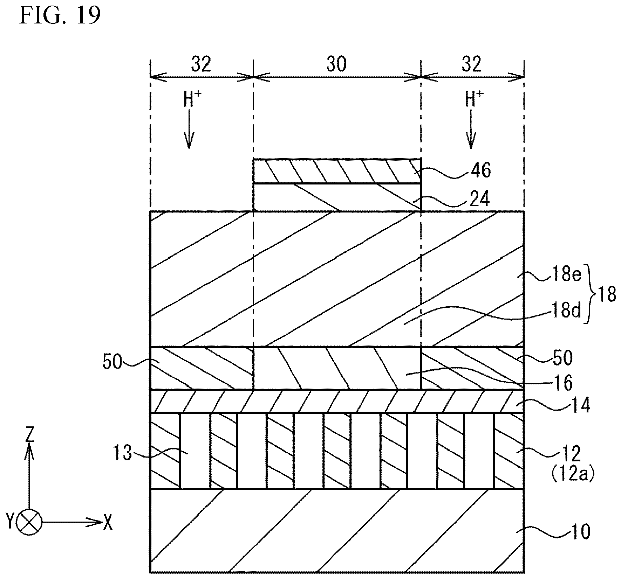

As illustrated in FIG. 19, contact layer 24 is epitaxially grown on the upper surface of cladding layer 18. Etching is performed using an insulating film 46 as a mask to form contact layer 24 into a circular shape. Hydrogen ions (protons, H⁺) are implanted from the upper surface of cladding layer 18 using insulating film 46 as a mask. A portion of cladding layer 18 that is not covered with insulating film 46 is insulated by implanting protons. An insulated portion is region 18e. Protons are not implanted into a portion covered with insulating film 46. Therefore, contact layer 24 still has a p-type conductivity type. A portion of cladding layer 18 under insulating film 46 serves as region 18d and has a p-type conductivity. Since active layer 16 is also protected by insulating film 46, protons are not implanted.

A depth of the proton implantation is approximately the same as a thickness of cladding layer 18. No protons are implanted into layers below cladding layer 18, i.e., passive layer 50, cladding layer 14, photonic crystal layer 12 and substrate 10. Cladding layer 14, photonic crystal layer 12 and substrate 10 maintain an n-type conductivity. The steps after the proton implantation are the same as those in the first embodiment.

According to the third embodiment, since region 18e of cladding layer 18 is a region that is insulated by proton implantation, current is less likely to flow in current blocking region 32. Current leakage from light emitting region 30 to current blocking region 32 can be suppressed, thereby improving characteristics of photonic crystal surface-emitting laser 300. Since passive layer 50 is adjacent to active layer 16, a light reflectance of current blocking region 32 is increased, thereby suppressing light loss.

It is preferable that the depth of proton implantation is approximately the same as a thickness of cladding layer 18, for example. Region 18e of cladding layer 18 in current blocking region 32 can be insulated throughout a depth direction. Current Leakage can be effectively suppressed. It is preferable that protons are not implanted into cladding layer 14. Ions other than protons may be implanted to be insulated.

The embodiments of the present disclosure have been described above in detail. However, the present disclosure is not limited to the specific embodiments, and various modifications and changes can be made within the scope of the gist of the present disclosure described in the claims.

### Reference Signs List

10 substrate (first semiconductor layer)
12 photonic crystal layer
12a base member (first region)
13 air hole (second region)
14 cladding layer (ninth semiconductor layer)
18 cladding layer (second semiconductor layer, third semiconductor layer)
18a, 18b, 18c cladding layer
22 cladding layer (second semiconductor layer, fifth semiconductor layer)
16 active layer
18d region (second semiconductor layer)
18e region (sixth semiconductor layer)
20 buried layer (fourth semiconductor layer)
21, 40, 42, 46 insulating film
23 thyristor
24 contact layer (eighth semiconductor layer)
25,28 electrode
26 pad
27 wiring line
30 light emitting region
32 current blocking region
34 aperture
50 passive layer (seventh semiconductor layer)
100, 100R, 200, 300 photonic crystal surface-emitting laser

## Claims

1. A photonic crystal surface-emitting laser comprising:
a light emitting region from which light is emitted in a direction crossing an in-plane direction; and
a current blocking region in which current is less likely to flow than in the light emitting region, the current blocking region being adjacent to the light emitting region in the in-plane direction,
wherein the light emitting region and the current blocking region each include a photonic crystal layer,
the photonic crystal layer has a first region and second regions periodically arranged in the in-plane direction in the first region,
a refractive index of each of the second regions is different from a refractive index of the first region,
the light emitting region includes a first semiconductor layer having a first conductivity type, an active layer having an optical gain, and a second semiconductor layer having a second conductivity type, and
the first semiconductor layer, the active layer, and the second semiconductor layer are sequentially stacked on top of one another in an emission direction of the light.

2. The photonic crystal surface-emitting laser according to claim 1,
wherein the current blocking region includes the first semiconductor layer, a third semiconductor layer having the second conductivity type, a fourth semiconductor layer having the first conductivity type, and a fifth semiconductor layer having the second conductivity type, and
the first semiconductor layer, the third semiconductor layer, the fourth semiconductor layer, and the fifth semiconductor layer are sequentially stacked on top of one another in the emission direction of the light to form a thyristor.

3. The photonic crystal surface-emitting laser according to claim 1,
wherein the current blocking region includes a sixth semiconductor layer, and
the sixth semiconductor layer is insulated.

4. The photonic crystal surface-emitting laser according to any one of claims 1 to 3,
wherein the active layer is included in the light emitting region and the current blocking region.

5. The photonic crystal surface-emitting laser according to any one of claims 1 to 3,
wherein the current blocking region includes a seventh semiconductor layer, and
the seventh semiconductor layer is adjacent to the active layer in the in-plane direction and has a bandgap greater than an energy of the light.

6. The photonic crystal surface-emitting laser according to any one of claims 1 to 5,
wherein the current blocking region surrounds a whole periphery of the light emitting region in the in-plane direction.

7. The photonic crystal surface-emitting laser according to any one of claims 1 to 6, further comprising:
an eighth semiconductor layer stacked on the second semiconductor layer and having the second conductivity type, in the light emitting region,
wherein at least a portion of the current blocking region is exposed from the eighth semiconductor layer.

8. The photonic crystal surface-emitting laser according to claim 7, further comprising:
a first electrode disposed on an upper surface of the eighth semiconductor layer and in the light emitting region; and
a second electrode disposed on a surface of the substrate, the surface being located on a side opposite to a side on which the first semiconductor layer is disposed,
wherein the first electrode has a ring-like shape in the in-plane direction, and
the eighth semiconductor layer is exposed at a portion of the light emitting region, the portion being surrounded by the first electrode.

9. The photonic crystal surface-emitting laser according to any one of claims 1 to 8,
wherein the first semiconductor layer, the photonic crystal layer, the active layer, and the second semiconductor layer are sequentially stacked on top of one another,
the photonic crystal surface-emitting laser includes a ninth semiconductor layer provided between the photonic crystal layer and the active layer and having the first conductivity type,
the photonic crystal layer has the first conductivity type,
the second regions of the photonic crystal are air holes, and
an end portion of each of the air holes on the active layer side is covered with the ninth semiconductor layer.

10. A method for manufacturing a photonic crystal surface-emitting laser, the method comprising:
forming a light emitting region from which light is emitted in a direction crossing an in-plane direction; and
forming a current blocking region in which current is less likely to flow than in the light emitting region, the current blocking region being adjacent to the light emitting region in the in-plane direction,
wherein the forming the light emitting region and the forming the current blocking region each include providing a photonic crystal layer,
the photonic crystal layer has a first region and second regions periodically arranged in the in-plane direction in the first region,
a refractive index of each of the second regions is different from a refractive index of the first region, and
the forming the light emitting region includes sequentially stacking a first semiconductor layer having a first conductivity type, an active layer having an optical gain, and a second semiconductor layer having a second conductivity type on top of one another.
